# EUROPEAN PATENT APPLICATION

(11) **EP 4 836 635 A1**
(43) Date of publication of application: **04.11.2026**
(21) Application number: 25189051.3
(22) Date of filing: 11.07.2025
(51) Int. Cl.: H10F 10/14, H10F 71/00, H10F 77/14, H10F 77/30

(54) **SOLAR CELL, PHOTOVOLTAIC MODULE AND PREPARATION METHOD OF SOLAR CELL**

(30) Priority: 30.04.2025 CN 202510570734
(71) Applicant: Shangrao Jinko Solar No.3 Intelligent Manufacturing Co., Ltd., Shangrao City, Jiangxi 333100 (CN); Zhejiang Jinko Solar Co., Ltd., Haining, Zhejiang 314416 (CN)
(72) Inventor: FANG, Lingxin, SHANGRAO CITY 333100 (CN); CAO, Jingyu, SHANGRAO CITY 333100 (CN); ZHANG, Yuanfang, SHANGRAO CITY 333100 (CN); WANG, Zhao, SHANGRAO CITY 333100 (CN); ZHENG, Peiting, SHANGRAO CITY 333100 (CN); YANG, Jie, SHANGRAO CITY 333100 (CN); ZHANG, Xinyu, SHANGRAO CITY 333100 (CN); GU, Wenxian, SHANGRAO CITY 333100 (CN)
(74) Representative: DREISS Patentanwälte PartG mbB

(57) **Abstract**

The present disclosure relates to the technical field of photovoltaics and, in particular, to a solar cell, a photovoltaic module and a preparation method of the solar cell. The solar cell includes a substrate, the substrate includes alight receiving surface and a back surface, the light receiving surface includes a first region and a second region, the back surface includes a third region and a fourth region, a first diffusion layer is located on the first region or inside the substrate corresponding to the first region, the first diffusion layer has an opposite conductivity type to the substrate, a second diffusion layer is located inside the substrate corresponding to the third region, the second diffusion layer has an opposite conductivity type to the first diffusion layer, a first passivation layer is located on the third region and the fourth region, the first passivation layer covers the second diffusion layer and is in contact with the substrate, a first electrode electrically connected to the first diffusion layer is arranged on the first region, and a second electrode electrically connected to the second diffusion layer is arranged on the third region. The above design improves the open-circuit voltage and the short-circuit current of the solar cell and improves the photoelectric conversion efficiency.

## Description

### TECHNICAL FIELD

The present disclosure relates to the technical field of photovoltaics and, in particular, to a solar cell, a photovoltaic module and a preparation method of the solar cell.

### BACKGROUND

Under a current energy shortage condition, a solar cell attracts extensive attention as a renewable resource, the solar cell is configured to convert solar energy into electric energy, and the current solar cell has the problem of a low photoelectric conversion efficiency, thus influencing the reliability of the solar cell.

### SUMMARY

In view of this, the present disclosure provides a solar cell, a photovoltaic module and a preparation method of the solar cell, so as to solve the problem of a low photoelectric conversion efficiency of a solar cell in the related art.

In a first aspect, embodiments of the present disclosure provide a solar cell, including a substrate, a first diffusion layer, a second diffusion layer, a first passivation layer, a first electrode and a second electrode. The substrate includes a light receiving surface and a back surface, the light receiving surface includes first regions and second regions arranged alternately, the back surface includes third regions and fourth regions arranged alternately, the first diffusion layer is located on the first regions or inside the substrate corresponding to the first regions, the first diffusion layer has an opposite conductivity type to the substrate, the second diffusion layer is located inside the substrate corresponding to the third regions, the second diffusion layer has an opposite conductivity type to the first diffusion layer, the first passivation layer is located on the third regions and the fourth regions, the first passivation layer covers the second diffusion layer and is in contact with the substrate, the first electrodes are arranged on the first regions in one-to-one correspondence and electrically connected to the first diffusion layer, the second electrodes are arranged on the third regions in one-to-one correspondence, and at least parts of structures of the first electrodes penetrate through the first passivation layer and are electrically connected to the second diffusion layer.

In a second aspect, embodiments of the present disclosure provide a photovoltaic module, including a encapsulation layer, a cover plate and at least one solar cell string, wherein the solar cell string includes a plurality of the above solar cells, the encapsulation layer covers a surface of the solar cell string, and the cover plate covers a surface of the encapsulation layer away from the solar cell string.

In a third aspect, embodiments of the present disclosure provide a preparation method of a solar cell, wherein a substrate of the solar cell includes a light receiving surface and a back surface, the light receiving surface includes first regions and second regions arranged alternately, the back surface includes third regions and fourth regions arranged alternately, and the preparation method of a solar cell includes: performing boron diffusion on the textured substrate to form a first diffusion layer and a borosilicate glass layer on the light receiving surface of the substrate, performing laser treatment on the second regions of the light receiving surface, performing phosphorus diffusion on the substrate with the borosilicate glass layer on the back surface removed to form a second diffusion layer and a phosphosilicate glass layer on the back surface of the substrate, performing laser treatment on the fourth regions of the back surface, performing first etching on the substrate with the phosphosilicate glass layer on the light receiving surface removed to remove the first diffusion layer and the borosilicate glass layer on the second regions and remove the second diffusion layer and the phosphosilicate glass layer on the fourth regions, performing second etching on the substrate to remove the borosilicate glass layer on the first regions and the phosphosilicate glass layer on the third regions, forming a first passivation layer on the back surface of the substrate, and performing laser-assisted sintering on the back surface of the substrate.

The present disclosure has the beneficial effects of reducing Auger recombination and surface recombination on a front surface of the substrate, prolonging the service life of minority carriers, and meanwhile reducing Auger recombination on a back surface of the substrate, reducing the recombination rate on the back surface of the substrate, and improving the passivation effect, thereby improving the open-circuit voltage and the short-circuit current of the solar cell and further improving the photoelectric conversion efficiency of the solar cell. The first passivation layer has better stability, and the passivation effect of the first passivation layer is not influenced by factors, such as doping element diffusion, so that the overall stability and reliability of the solar cell are improved while the electrical performance of the solar cell is improved. The first passivation layer can reduce the recombination rate of the surface of the substrate, prolong the service life of the minority carriers and improve the open-circuit voltage and the short-circuit current. The first passivation layer is easy to prepare, and steps, such as deposition of polycrystalline silicon and introduction of doping elements, are avoided, thereby simplifying a production process of the solar cell and reducing the preparation difficulty and the preparation cost of the solar cell.

It is to be understood that both the foregoing general description and the following detailed description are exemplary only and are not intended to limit the present disclosure.

### BRIEF DESCRIPTION OF DRAWINGS

To better describe the technical solutions in embodiments of the present disclosure, the following briefly describes the accompanying drawings required for the embodiments. Apparently, the accompanying drawings in the following description show merely some embodiments of the present disclosure, and a person of ordinary skill in the art may still derive other drawings from these accompanying drawings without creative efforts.
FIG. 1 is a schematic structural diagram of a solar cell according to one or more embodiments of the present disclosure;
FIG. 2 is a schematic structural diagram of a first anti-reflection layer and a first passivation layer according to one or more embodiments of the present disclosure;
FIG. 3 is a schematic structural diagram of a photovoltaic module according to one or more embodiments of the present disclosure;
FIG. 4 is a schematic diagram of a textured substrate according to one or more embodiments of the present disclosure;
FIG. 5 is a schematic diagram of the substrate after boron diffusion according to one or more embodiments of the present disclosure;
FIG. 6 is a schematic diagram of positions of a first region and a second region on the substrate according to one or more embodiments of the present disclosure;
FIG. 7 is a schematic diagram of the substrate after removal of a borosilicate glass layer on a back surface according to one or more embodiments of the present disclosure;
FIG. 8 is a schematic diagram of the substrate after phosphorus diffusion according to one or more embodiments of the present disclosure;
FIG. 9 is a schematic diagram of positions of a third region and a fourth region on the substrate according to one or more embodiments of the present disclosure;
FIG. 10 is a schematic diagram of the substrate after removal of a phosphosilicate glass layer on a light receiving surface according to one or more embodiments of the present disclosure;
FIG. 11 is a schematic diagram of the substrate after first etching according to one or more embodiments of the present disclosure;
FIG. 12 is a schematic diagram of the substrate after second etching according to one or more embodiments of the present disclosure;
FIG. 13 is a schematic diagram of formation of a second passivation layer on the light receiving surface of the substrate according to one or more embodiments of the present disclosure;
FIG. 14 is a schematic diagram of formation of the first passivation layer on the back surface of the substrate according to one or more embodiments of the present disclosure;
FIG. 15 is a schematic diagram of formation of a second anti-reflection layer on one side of the second passivation layer according to one or more embodiments of the present disclosure;
FIG. 16 is a schematic diagram of formation of the first anti-reflection layer on one side of the first passivation layer according to one or more embodiments of the present disclosure;
FIG. 17 is a schematic structural diagram of the solar cell according to one or more embodiments of the present disclosure; and
FIG. 18 is a flowchart of a preparation method of a solar cell according to one or more embodiments of the present disclosure.

### Reference signs:

1000-photovoltaic module; 100-solar cell string; 10-solar cell; 11-substrate; 111-light receiving surface; 1111-first region; 1112-second region; 112-back surface; 1121-third region; 1122-fourth region; 121-first diffusion layer; 122-borosilicate glass layer; 131-second diffusion layer; 132-phosphosilicate glass layer; 14-first passivation layer; 15-first anti-reflection layer; 151-silicon oxynitride layer; 152-silicon nitride layer; 153-silicon oxide layer; 16-second passivation layer; 17-second anti-reflection layer; 18-first electrode; 19-second electrode; 200-first cover plate; 300-second cover plate; 400-first encapsulation layer; 500-second encapsulation layer.

### DESCRIPTION OF EMBODIMENTS

In order to better understand the technical solution of the present disclosure, embodiments of the present disclosure are described in detail below with reference to the accompanying drawings.

It should be clear that the described embodiments are merely some but not all of the embodiments of the present disclosure. All other embodiments obtained by a person of ordinary skill in the art based on the embodiments of the present disclosure without creative efforts shall fall within the protection scope of the present disclosure.

The terminology used in embodiments of the present disclosure is for the purpose of describing particular embodiments only and is not intended to limit the present disclosure. As used in embodiments of the present disclosure and the appended claims, "a" and "the" in singular forms mean including plural forms, unless clearly indicated in the context otherwise.

It should be understood that the term "and/or" as used herein is merely an association relationship describing associated objects, indicating that three relationships may exist. For example, A and/or B indicates that there are three cases of A alone, A and B together, and B alone. In addition, the character "/" herein generally means that associated objects before and after "/"are in an "or" relationship.

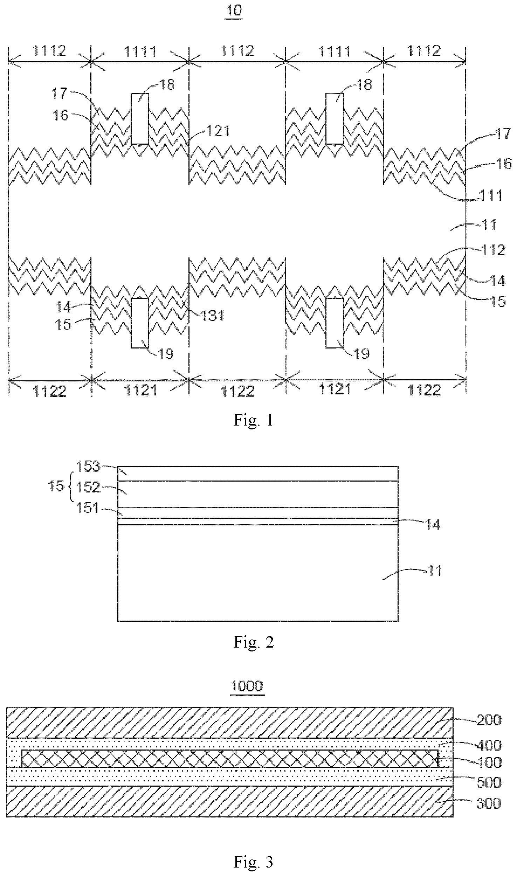

As shown in FIG. 1, embodiments of the present disclosure provide a solar cell 10, including a substrate 11, a first diffusion layer 121, a second diffusion layer 131, a first passivation layer 14, a first electrode 18 and a second electrode 19.

The substrate 11 may be an N-type substrate or a P-type substrate. The N-type substrate may be a silicon substrate doped with an N-type element, and in some embodiments, the N-type element may be one or a combination of pentavalent elements, such as phosphorus, arsenic and antimony. The P-type substrate may be a silicon substrate doped with a P-type element, and in some embodiments, the P-type element may be one or a combination of trivalent elements, such as boron, indium and gallium. The structure of the solar cell is described below by taking the substrate as an N-type silicon substrate as an example.

The substrate 11 includes a light receiving surface 111 and a back surface 112. The light receiving surface 111 is a surface which can be directly irradiated by sunlight (i.e., a light receiving surface), the light receiving surface 111 can be regarded as a front surface of the substrate 11, the back surface 112 is a surface not directly irradiated by sunlight (i.e., a backlight surface), and the back surface 112 can be regarded as a back surface of the substrate 11. The light receiving surface 111 and the back surface 112 can both receive sunlight and convert light energy into electric energy.

The light receiving surface 111 includes first regions 1111 and second regions 1112 arranged alternately, the first regions 1111 are metalized regions, that is, the first regions 1111 are regions where metal electrodes (i.e., the first electrodes 18) of the light receiving surface 111 are located, and a width of the first regions 1111 may be greater than a width of the first electrodes 18. The second regions 1112 may be non-metalized regions of the light receiving surface 111, that is, the second regions 1112 are regions of the light receiving surface 111 other than the first regions 1111. The back surface 112 includes third regions 1121 and fourth regions 1122 arranged alternately, the third regions 1121 are metalized regions, that is, the third regions 1121 are regions where metal electrodes (i.e., the second electrodes 19) of the back surface 112 are located, and a width of the third regions 1121 may be greater than a width of the second electrodes 19. The fourth regions 1122 may be non-metalized regions of the back surface 112, that is, the fourth regions 1122 are regions of the back surface 112 other than the third regions 1121.

The first diffusion layer 121 is located on the first regions 1111 or inside the substrate 11 corresponding to the first regions 1111, and the first diffusion layer 121 has an opposite conductivity type to the substrate 11. The conduction type of the first diffusion layer 121 may be P-type, and the first diffusion layer 121 and the substrate 11 may form a PN junction, so that under a light irradiation condition of the solar cell 10, under the action of a built-in electric field in the PN junction, photo-generated carriers (electron-hole pairs) are effectively separated, and electrons and holes are gathered in different regions, thereby generating a current. The first electrodes 18 are arranged on the first regions 1111 in one-to-one correspondence, and are electrically connected to the first diffusion layer 121 to form a current path.

The second diffusion layer 131 is located inside the substrate 11 corresponding to the third regions 1121, and the second diffusion layer 131 has an opposite conductivity type to the first diffusion layer 121. The conduction type of the third diffusion layer may be N-type. The first passivation layer 14 is located on the third regions 1121 and the fourth regions 1122, that is, the first passivation layer 14 is arranged on the entire region of the back surface 112. The first passivation layer 14 covers the second diffusion layer 131 and contacts the substrate 11. The second electrodes 19 are arranged on the third regions 1121 in one-to-one correspondence, and at least parts of structures of the first electrodes 18 penetrate through the first passivation layer 14 and are electrically connected to the second diffusion layer 131 to form a current path.

In the related art, the first diffusion layer is arranged on the whole front surface of the solar cell, the second diffusion layer is arranged on the whole back surface of the solar cell, that is, the first diffusion layer is formed on the first region and the second region of the light receiving surface at the same time, the second diffusion layer is formed on the third region and the fourth region of the back surface at the same time, and a side of the second diffusion layer away from the substrate is further provided with a doped polycrystalline silicon layer, which results in a large amount of Auger recombination and surface recombination on the front surface of the solar cell, thereby resulting in loss of the open-circuit voltage of the solar cell. Meanwhile, a large amount of parasitic absorption of light exists on the back surface of the solar cell, thereby resulting in loss of the short-circuit current of the solar cell, thereby affecting the efficiency of the solar cell.

Compared with the related art, in the embodiments of the present disclosure, the first diffusion layer 121 is arranged on the first regions 1111 (or inside the substrate 11 corresponding to the first regions 1111), and the first diffusion layer 121 is not arranged on the second regions 1112, so that the first diffusion layer 121 forms the PN junction only together with the substrate 11 corresponding to the first regions 1111, so as to reduce the Auger recombination and the surface recombination on the front surface of the substrate 11, improve the service life of minority carriers, and improve the open-circuit voltage and the short-circuit current of the solar cell 10, thereby improving the electrical performance of the solar cell 10. The second diffusion layer 131 is arranged on the third regions 1121, and the second diffusion layer 131 is not arranged on the fourth regions 1122, so that Auger recombination on the back surface of the substrate 11 is reduced, the recombination rate on the back surface of the substrate 11 is reduced, and the passivation effect is improved.

In the embodiments of the present disclosure, the doped polycrystalline silicon layer on the back surface of the substrate 11 is eliminated, the first passivation layer 14 in contact with the substrate 11 is arranged, and field passivation of the first passivation layer 14 is realized on the surface of the substrate 11, so that the recombination rate of the surface of the substrate 11 is reduced, the service life of the minority carriers is prolonged, and the open-circuit voltage and the short-circuit current are improved, thereby improving the efficiency of the solar cell 10 and then improving the reliability of the solar cell 10. Compared with the doped polycrystalline silicon layer, the first passivation layer 14 has better stability, and the passivation effect of the first passivation layer is not influenced by factors, such as doping element diffusion, so that the overall stability and reliability of the solar cell 10 are improved while the electrical performance of the solar cell 10 is improved. Meanwhile, the first passivation layer 14 is easy to prepare, and steps, such as deposition of polycrystalline silicon and introduction of doping elements, are avoided, thereby simplifying a production process of the solar cell 10 and reducing the preparation difficulty and the preparation cost of the solar cell 10. On the other hand, in the preparation process of the solar cell 10, a laser-assisted sintering technology is generally used to realize good ohmic contact between the substrate 11 and the electrode, reduce contact resistance, and improve a current collection effect. The laser-assisted sintering technology has a limited effect in the case where the doped polycrystalline silicon layer is arranged on the back surface of the solar cell 10. In the embodiments of the present disclosure, since there is no limitation of the doped polycrystalline silicon layer, the surface of the substrate 11 can be processed by fully using the laser-assisted sintering technology, so as to realize the good ohmic contact between the second electrode 19 and the substrate 11, and optimize the electrical performance of the solar cell 10.

In summary, for the solar cell 10 according to the embodiments of the present disclosure, the recombination and parasitic absorption on the surface of the substrate 11 are reduced, and the open-circuit voltage and the short-circuit current of the solar cell 10 are increased, thereby realizing the design of the efficient solar cell 10.

In one or more possible implementations, the first passivation layer 14 has fixed negative charges. The negative charge attribute of the first passivation layer 14 realizes field passivation by adjusting and controlling an energy band structure and carrier distribution of the substrate 11, so that the passivation effect of the first passivation layer 14 is improved, and the open-circuit voltage and the short-circuit current of the solar cell 10 are improved, thereby improving the photoelectric conversion efficiency of the solar cell 10.

As shown in FIG. 1, in one or more possible implementations, the first passivation layer 14 is made of one or more of aluminum oxide, silicon oxynitride, zirconium oxide, hafnium oxide and arsenic oxide, and the thickness D1 of the first passivation layer 14 satisfies: 0.8nm≤D1≤3nm.

By selecting the above materials, the first passivation layer 14 has a good passivation effect and stable chemical properties, and the possibility that the first passivation layer is influenced by external factors (such as a temperature, humidity, or the like) is reduced, thereby facilitating prolonging of the service life of the solar cell 10, and improving the reliability of the solar cell 10.

The thickness D1 of the first passivation layer 14 may be 0.8nm, 0.9nm, 1nm, 1.2nm, 1.4nm, 1.6nm, 1.8nm, 2nm, 2.2nm, 2.4nm, 2.6nm, 2.8nm, or 3nm, and certainly may be other values within the above range. By limiting the thickness of the first passivation layer 14 within the above range, the first passivation layer 14 has high reliability, so that the recombination rate of the surface of the substrate 11 is effectively reduced, a field passivation effect is enhanced, and meanwhile, the contact resistance between the substrate 11 and the electrode is favorably reduced, and optical parasitic absorption is favorably reduced, thereby favorably improving the optical performance of the solar cell 10.

In some embodiments, the first passivation layer is an aluminum oxide layer. The aluminum oxide has a good passivation effect, reduces the recombination rate of carriers on the surface of the substrate, and effectively improves the open-circuit voltage and the short-circuit current of the solar cell. Meanwhile, the aluminum oxide also has a good optical performance to improve the light utilization rate of the solar cell, thereby improving the electrical performance of the solar cell.

In some embodiments, the first passivation layer is a zirconium oxide layer, and the zirconium oxide has a stable chemical performance and can withstand extreme conditions, such as a high voltage and a high temperature, so that the stability and reliability of the solar cell are improved while a good passivation effect is achieved.

In some embodiments, the first passivation layer is a hafnium oxide layer, and the hafnium oxide effectively enhances electric field effect, thereby better realizing field passivation, reducing the recombination of the carriers on the back surface of the solar cell, prolonging the service life of the minority carriers, and increasing the open-circuit voltage of the solar cell. Meanwhile, the hafnium oxide can reduce parasitic absorption, improve the light utilization rate of the solar cell and then increase the short-circuit current of the solar cell.

As shown in FIG. 1, in one or more possible implementations, the solar cell 10 further includes a first anti-reflection layer 15, the first anti-reflection layer 15 is located on a side of the first passivation layer 14 away from the substrate 11, and the thickness D2 of the first anti-reflection layer 15 satisfies: 60nm≤D2≤100nm.

The first anti-reflection layer 15 is configured to reduce optical reflection, achieve a passivation effect and meanwhile stabilize and protect the first passivation layer 14. At least a part of the structure of the second electrode 19 penetrates through the first anti-reflection layer 15 and the first passivation layer 14 and is electrically connected to the second diffusion layer 131.

The thickness D2 of the first anti-reflection layer 15 may be 60 nm, 65 nm, 70 nm, 75 nm, 80 nm, 85 nm, 90 nm, 95 nm, or 100 nm, and certainly may be other values within the above range. The excessively small or large thickness of the first anti-reflection layer 15 may affect the optical performance and the passivation effect of the first anti-reflection layer 15, resulting in an increase in the reflectivity of the surface of the substrate 11 and a decrease in the passivation effect, thereby affecting the electrical performance of the solar cell 10. On the other hand, if the first anti-reflection layer 15 is excessively thin, the mechanical performance of the first anti-reflection layer 15 may be poor, and cracks may be easily generated in subsequent screen printing and other links, thereby reducing the yield of the solar cell 10. If the first anti-reflection layer 15 is excessively thick, the adhesion of metal paste may be reduced, and the risk of an electrode fracture or delamination of the electrode from the substrate 11 may be increased, thereby affecting normal use of the solar cell 10. Therefore, the thickness of the first anti-reflection layer 15 is limited within the above range, so as to improve the mechanical strength of the first anti-reflection layer 15 while ensuring that the first anti-reflection layer 15 achieves a good anti-reflection effect and passivation effect, thus improving the arrangement stability and reliability of the second electrode 19, and then ensuring normal and stable working of the solar cell 10.

As shown in FIG. 2, in one or more possible implementations, the first anti-reflection layer 15 includes a silicon oxynitride layer 151, a silicon nitride layer 152 and a silicon oxide layer 153 arranged in a direction away from the substrate 11. That is, the first anti-reflection layer 15 has a stacked design, and the silicon oxynitride layer 151 is located at a bottommost layer of the first anti-reflection layer 15. That is, the silicon oxynitride layer 151 is located on a side of the silicon nitride layer 152 close to the substrate 11, and correspondingly, the silicon oxide layer 153 is located on a side of the silicon nitride layer 152 away from the substrate 11.

The stacked design of the silicon oxynitride layer 151, the silicon nitride layer 152 and the silicon oxide layer 153 realizes a gradient design of the refractivity of the first anti-reflection layer 15, thereby optimizing the optical performance of the first anti-reflection layer 15, improving the anti-reflection effect of the first anti-reflection layer 15, and then improving the electrical performance of the solar cell 10. The silicon oxynitride layer 151 may contact the first passivation layer 14, and the silicon oxynitride layer 151 may also have a negative charge, so as to fit with the first passivation layer 14 having the negative charge, thereby improving the passivation effect on the surface of the substrate 11, reducing the recombination rate on the surface of the substrate 11, and increasing the open-circuit voltage of the solar cell 10. The silicon nitride layer 152 may achieve a hydrogen passivation function to repair dangling bonds on the surface of the substrate 11 and reduce the recombination rate on the surface of the substrate 11. The silicon oxide layer 153 is located at a top of the first anti-reflection layer 15 and can effectively reduce parasitic absorption of light, the chemical property of the silicon oxide layer 153 is relatively stable, and the silicon oxide layer has an isolation effect on the silicon nitride layer 152 and the silicon oxynitride layer 151, so as to reduce the possibility that external water vapor enters the silicon nitride layer 152 and the silicon oxynitride layer 151 to affect the performance of the first anti-reflection layer 15. Furthermore, the silicon oxide layer 153 is located at the top of the first anti-reflection layer 15, which facilitates adjustment of the color of the first anti-reflection layer 15, so as to improve the optical performance of the first anti-reflection layer 15.

The thickness D3 of the silicon oxide layer 153 satisfies: 10nm≤D3≤30nm. For example, D3 may be 10nm, 13nm, 15nm, 16nm, 19nm, 20mm, 22nm, 25nm, 28nm or 30nm, and certainly may be other values within the above range. By limiting the thickness of the silicon oxide layer 153, the silicon oxide layer has a good anti-reflection effect to improve the transmittance of light, and has a reliable mechanical performance to protect the silicon nitride layer 152 and the silicon oxynitride layer 151, thereby improving the stability and reliability of the first anti-reflection layer 15, and prolonging the service life of the solar cell 10.

The thickness D4 of the silicon nitride layer 152 satisfies: 20nm≤D4≤30nm. For example, D4 may be 20nm, 21nm, 22nm, 23nm, 24nm, 25mm, 26nm, 27nm, 28nm, 29nm or 30nm, and certainly may be other values within the above range. By limiting the thickness of the silicon nitride layer 152, the silicon nitride layer 152 can form good optical matching with the silicon oxide layer 153 and the silicon oxynitride layer 151, so that a broad-spectrum anti-reflection effect is achieved, and meanwhile the hydrogen passivation effect of the silicon nitride layer 152 is improved.

The thickness D5 of the silicon oxynitride layer 151 satisfies: 5nm≤D5≤15nm. For example, D5 may be 5nm, 6nm, 7nm, 8nm, 9nm, 10mm, 11nm, 12nm, 13nm, 14nm or 15nm, and certainly may be other values within the above range. By limiting the thickness of the silicon nitride layer 152, the silicon nitride layer 152 is ensured to well fit with the first passivation layer 14 to improve the passivation effect on the substrate 11, and meanwhile, the silicon oxynitride layer 151 has a good anti-reflection capability, so that the reflection of light on the surface of the substrate 11 is reduced, and the electrical performance of the solar cell 10 is improved.

As shown in FIG. 1, in one or more possible implementations, the first diffusion layer 121 includes a first doping element, and the doping concentration of the first diffusion layer 121 is 1E19cm⁻³ to 1E20cm⁻³. The second diffusion layer 131 includes a second doping element, and the doping concentration of the second diffusion layer 131 is 1E20cm⁻³ to 5E20cm⁻³.

The conduction type of the first diffusion layer 121 may be P-type, and the doping element in the first diffusion layer 121 may be a trivalent element, such as boron, aluminum or gallium. The conduction type of the second diffusion layer 131 may be N-type, and the doping element in the second diffusion layer 131 may be a pentavalent element, such as phosphorus, arsenic or antimony. The limitation of the doping concentration of the first diffusion layer 121 and the doping concentration of the second diffusion layer 131 facilitates a reduction of the contact resistance between the substrate 11 and the electrode, reduces the series resistance of the solar cell, and meanwhile improves the passivation effect of the surface of the substrate 11, reduces the recombination of the carriers, prolongs the service life of the minority carriers, and then increases the open-circuit voltage and the short-circuit current of the solar cell 10, and improves the photoelectric conversion efficiency of the solar cell 10.

In some other embodiments, the doping concentration of the first diffusion layer 121 is 1E19cm⁻³ to 1E20cm⁻³, or the doping concentration of the second diffusion layer 131 is 1E20cm⁻³ to 5E20cm⁻³.

As shown in FIG. 1, in one or more possible implementations, the solar cell 10 further includes a second passivation layer 16 and a second anti-reflection layer 17, the second passivation layer 16 is located on the first regions 1111 and the second regions 1112, the second passivation layer 16 covers the first diffusion layer 121 and is in contact with the substrate 11, the second passivation layer 16 has a positive charge, and the second anti-reflection layer 17 is located on a side of the second passivation layer 16 away from the substrate 11.

At least a part of the structure of the first electrode 18 penetrates through the second anti-reflection layer 17 and the second passivation layer 16 and is electrically connected to the first diffusion layer 121. The second passivation layer 16 has fixed positive charges, and in some embodiments, the second passivation layer 16 may be made of one or more of silicon oxide, silicon nitride, aluminum oxide, aluminum nitride, and silicon hydrogen nitride. It should be noted that the aluminum oxide itself has fixed negative charges, and when the aluminum oxide is arranged on the light receiving surface 111 of the substrate 11 as the second passivation layer 16, the density of the fixed negative charge of the aluminum oxide is decreased and the positive charge of the aluminum oxide is increased after long-time high-temperature annealing, so that the aluminum oxide has a positive charge, that is, the aluminum oxide can be regarded as having fixed positive charges. The second passivation layer 16 forms an electric field on the front surface of the substrate 11, and surface electric field distribution is optimized through electric field modulation effect, thereby reducing the recombination of the minority carriers and prolonging the service life of the minority carriers. The second passivation layer 16 may achieve a field passivation function and/or a hydrogen passivation function, thereby increasing the open-circuit voltage and the short-circuit current of the solar cell 10 and improving the photoelectric conversion efficiency of the solar cell 10.

The thickness D6 of the second passivation layer 16 satisfies: 0.8nm≤D6≤3nm. For example, D6 may be 0.6 nm, 0.7 nm, 0.8 nm, 0.9 nm, 1 nm, 1.2 nm, 1.4 nm, 1.6 nm, 1.8 nm, 2 nm, 2.2 nm, 2.4 nm, 2.6 nm, 2.8 nm or 3 nm, and certainly may be other values within the above range. By limiting the thickness of the second passivation layer 16 within the above range, the reliability of the second passivation layer 16 is improved, so that the recombination rate of the surface of the substrate 11 is effectively reduced, the passivation effect is enhanced, and meanwhile, a reduction of parasitic absorption of light is facilitated, thereby facilitating an improvement of the optical performance of the solar cell 10.

The second anti-reflection layer 17 may be a silicon oxide layer, a silicon nitride layer, or a silicon oxynitride layer. The second anti-reflection layer 17 can achieve an anti-reflection function and passivate the surface of the substrate 11, thereby improving the electrical performance of the solar cell 10.

The thickness D7 of the second anti-reflection layer 17 satisfies: 60 nm≤D7≤100 nm. For example, D7 may be 60 nm, 65 nm, 70 nm, 75 nm, 80 nm, 85 nm, 90 nm, 95 nm or 100 nm, and certainly may be other values within the above range. The excessively small or large thickness of the second anti-reflection layer 17 may affect the optical performance and the passivation effect of the second anti-reflection layer 17, resulting in an increase in the reflectivity of the surface of the substrate 11 and a decrease in the passivation effect, thereby affecting the electrical performance of the solar cell 10. If the second anti-reflection layer 17 is excessively thin, the mechanical performance of the second anti-reflection layer 17 may be poor, and cracks may be easily generated in subsequent screen printing and other links, thereby reducing the yield of the solar cell 10. If the second anti-reflection layer 17 is excessively thick, the adhesion of electrode paste may be reduced, and the risk of an electrode fracture or delamination of the electrode from the substrate 11 may be increased, thereby affecting normal use of the solar cell 10. Therefore, the thickness of the second anti-reflection layer 17 is limited within the above range, so as to improve the mechanical strength of the second anti-reflection layer 17 while ensuring the good anti-reflection effect and passivation effect of the second anti-reflection layer 17, thus improving the arrangement stability and reliability of the first electrode 18, and then ensuring normal and stable working of the solar cell 10.

In some other embodiments, the thickness D6 of the second passivation layer 16 satisfies: 0.8 nm≤D6≤3 nm, or the thickness D7 of the second anti-reflection layer 17 satisfies: 60 nm≤D7≤100 nm.

As shown in FIG. 1, in some embodiments, the first region 1111 and the second region 1112 of the light receiving surface 111 are both textured, that is, the first region 1111 and the second region 1112 of the substrate 11 are both provided with pyramid structures, so as to effectively reduce the reflectivity of incident light, that is, reduce the loss of reflected light from the light receiving surface 111, and allow more photons to enter the substrate 11, thereby improving the efficiency of the solar cell 10.

In some embodiments, there is a height difference between the first region 1111 and the second region 1112, so that the first region 1111 and the second region 1112 are separated from each other, that is, the first region 1111 and the second region 1112 are no longer in the same horizontal plane, thereby facilitating positioning of the first electrode 18 and then facilitating printing of the metal paste.

In some embodiments, the third region 1121 and the fourth region 1122 of the back surface 112 are both textured, that is, the third region 1121 and the fourth region 1122 of the substrate 11 are both provided with pyramid structures, so as to reduce the loss of reflected light from the back surface 112, and allow more photons to enter the substrate 11, thereby improving the efficiency of the solar cell 10.

In some embodiments, there is a height difference between the third region 1121 and the fourth region 1122, so that the third region 1121 and the fourth region 1122 are separated from each other, that is, the third region 1121 and the fourth region 1122 are no longer in the same horizontal plane, thereby facilitating positioning of the second electrode 19 and then facilitating printing of the metal paste.

In some embodiments, the third region and the fourth region of the back surface are polished to reduce defects and contamination on the surface of the substrate, so as to improve the stability and reliability of the solar cell.

In some embodiments, the third region of the back surface is polished, and the fourth region of the back surface is textured. Or, the third region of the back surface is textured, and the fourth region of the back surface is polished.

As shown in FIG. 3, embodiments of the present disclosure provide a photovoltaic module 1000, including an encapsulation layer, a cover plate, and at least one solar cell string 100. The encapsulation layer covers a surface of the solar cell string 100, and the cover plate covers a surface of the encapsulation layer away from the solar cell string 100. The cover plate at a top of the photovoltaic module 1000 is a first cover plate 200, the cover plate at a bottom of the photovoltaic module 1000 is a second cover plate 300, the encapsulation layer between the first cover plate 200 and the solar cell string 100 is a first encapsulation layer 400, and the encapsulation layer between the second cover plate 300 and the solar cell string 100 is a second encapsulation layer 500. The photovoltaic module 1000 includes the first cover plate 200, the second cover plate 300, the first encapsulation layer 400, the second encapsulation layer 500, and the solar cell string 100, and the solar cell string 100 includes a plurality of the above solar cells 10.

The first cover plate 200, the first encapsulation layer 400, the solar cell string 100, the second encapsulation layer 500, and the second cover plate 300 may be arranged in a thickness direction of the photovoltaic module 1000 and laminated together. The first cover plate 200 may be a glass cover plate, and the first cover plate 200 has a high light transmittance. The first encapsulation layer 400 bonds the first cover plate 200 and the solar cell string 100 together to package and protect the solar cell string 100, and a material of the first encapsulation layer 400 may be one or more of an ethylene-vinyl acetate copolymer (EVA), a polyolefin elastomer (POE), and polyvinyl butyral (PVB). The second encapsulation layer 500 connects the solar cell string 100 with the second cover plate 300, and also packages and protects the solar cell string 100, and a material of the second encapsulation layer 500 may be one or more of the above-mentioned EVA, POE, and PVB. A material of the second cover plate 300 may be glass, or the second cover plate 300 may be formed by compounding a plurality of polymer films.

Hereinafter, a preparation method of the above solar cell will be described in detail.

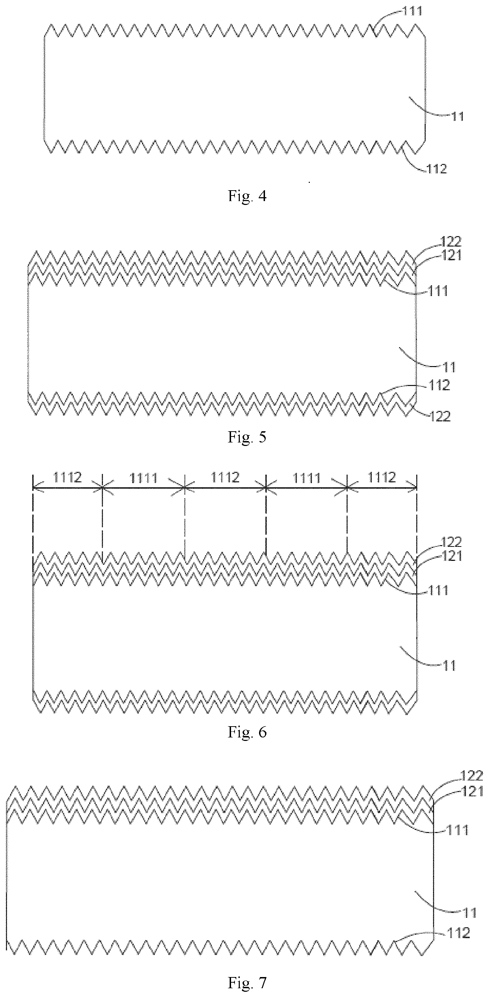

An embodiment of the present disclosure provides a preparation method of a solar cell, including:
S601: as shown in FIG. 4, providing a substrate 11, cleaning and texturing the substrate 11.

In the step S601, the substrate 11 may be first cleaned to remove stains and impurities on a surface of the substrate 11, and then, a light receiving surface 111 and a back surface 112 of the substrate 11 are etched to make the light receiving surface 111 and the back surface 112 become textured surfaces, even if the light receiving surface 111 and the back surface 112 have pyramid structures.

S602: as shown in FIG. 5, performing boron diffusion on the textured substrate 11 to form a first diffusion layer 121 and a borosilicate glass layer 122 on the light receiving surface 111 of the substrate 11.

In the step S602, a boron diffusion source may be borane bromide (e.g., BBr₃) with a sheet resistance of 50Ω/sqr to 300Ω/sqr. In some embodiments, the thickness of the borosilicate glass layer 122 formed on the light receiving surface 111 is 10nm to 30nm. In some embodiments, the doping concentration of the first diffusion layer 121 is 1E19cm⁻³ to 1E20cm⁻³.

With continued reference to FIG. 5, after the step S602, the back surface 112 of the substrate 11 has the borosilicate glass layer 122.

S603: as shown in FIG. 6, performing laser treatment on second regions 1112 of the light receiving surface 111.

In the step S603, by the laser treatment of the second region 1112, the borosilicate glass layer 122 in the second region 1112 is modified, that is, the laser-treated borosilicate glass layer 122 has a porosity higher than that of the non-laser-treated borosilicate glass layer 122, so as to facilitate removal of the borosilicate glass layer 122 and the first diffusion layer 121 on the second region 1112 in a subsequent step.

In some embodiments, laser in the step S603 may be nanosecond laser, picosecond laser, or femtosecond laser.

S604: removing the borosilicate glass layer 122 on the back surface 112 to form the structure shown in FIG. 7.

In the step S604, the substrate 11 may be subjected to acid pickling by a hydrofluoric acid solution to remove the borosilicate glass layer 122 on the back surface 112 of the substrate 11.

S605: texturing or polishing the back surface 112 of the substrate 11.

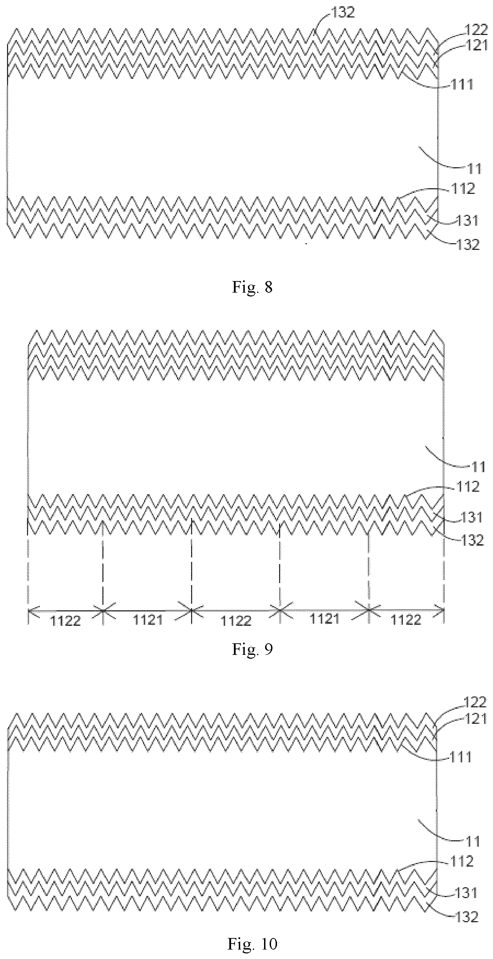

S606: as shown in FIG. 8, performing phosphorus diffusion on the substrate 11 with the borosilicate glass layer 122 on the back surface 112 removed to form a second diffusion layer 131 and a phosphosilicate glass layer 132 on the back surface 112 of the substrate 11.

In the step S606, a phosphorus diffusion source may be phosphorus oxychloride (POCl₃), and in some embodiments, the doping concentration of the second diffusion layer 131 is 1E20 cm⁻³ to 5E20 cm⁻³.

After the step S606, the light receiving surface 111 of the substrate 11 also has the phosphosilicate glass layer 132, that is, the structure shown in FIG. 8 is formed.

S607: as shown in FIG. 9, performing laser treatment on fourth regions 1122 of the back surface 112.

In the step S607, by the laser treatment of the fourth region 1122, the phosphosilicate glass layer 132 in the fourth region 1122 is modified, that is, the laser-treated phosphosilicate glass layer 132 has a porosity higher than that of the non-laser-treated phosphosilicate glass layer 132, so as to facilitate removal of the phosphosilicate glass layer 132 and the second diffusion layer 131 on the fourth region 1122 in a subsequent step.

In some embodiments, laser in the step S607 may be nanosecond laser, picosecond laser, or femtosecond laser.

S608: removing the phosphosilicate glass layer 132 on the light receiving surface 111 to form the structure shown in FIG. 10.

In the step S608, the substrate 11 may be subjected to acid pickling by a hydrofluoric acid solution to remove the phosphosilicate glass layer 132 on the light receiving surface 111 of the substrate 11.

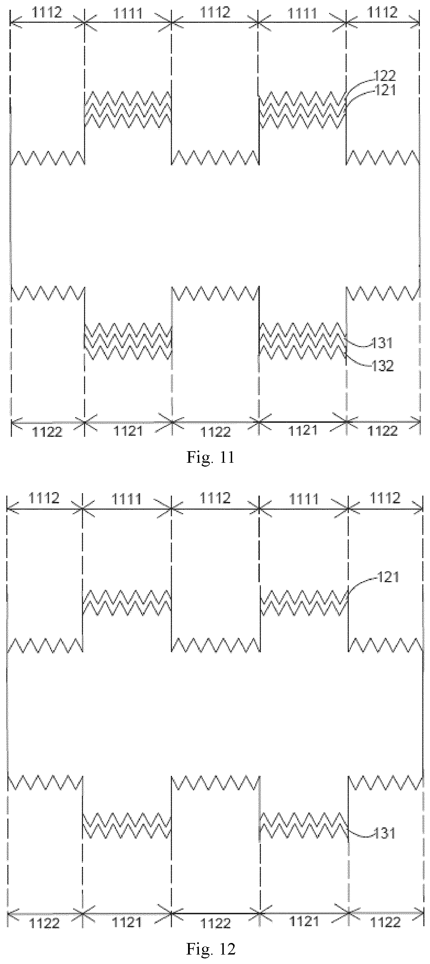

S609: performing first etching on the substrate 11 with the phosphosilicate glass layer 132 on the light receiving surface 111 removed to remove the first diffusion layer 121 and the borosilicate glass layer 122 on the second regions 1112 and remove the second diffusion layer 131 and the phosphosilicate glass layer 132 on the fourth regions 1122, so as to form the structure shown in FIG. 11.

In the step S609, the substrate 11 may be etched by using a chemical solution, and since the second region 1112 of the light receiving surface 111 and the fourth region 1122 of the back surface 112 are subjected to the laser treatment, and the borosilicate glass layer 122 on the second region 1112 and the phosphosilicate glass layer 132 on the fourth region 1122 are modified, the rate of etching of the borosilicate glass layer 122 on the second region 1112 and the phosphosilicate glass layer 132 on the fourth region 1122 by the etching solution is increased, thereby removing the borosilicate glass layer 122 on the second region 1112 and the first diffusion layer 121 directly facing the part of the borosilicate glass layer 122, and removing the phosphosilicate glass layer 132 on the fourth region 1122 and the second diffusion layer 131 directly facing the part of the phosphosilicate glass layer 132. The first region 1111 of the light receiving surface 111 and the third region 1121 of the back surface 112 are not subjected to laser treatment, so that both the borosilicate glass layer 122 of the first region 1111 and the phosphosilicate glass layer 132 of the third region 1121 can be used as protective layers, and the first diffusion layer 121 of the first region 1111 and the second diffusion layer 131 of the second region 1112 are not etched and remain.

As shown in FIG. 11, after the step S609, the first region 1111 and the second region 1112 of the light receiving surface 111 form a height difference, and the third region 1121 and the fourth region 1122 of the back surface 112 form a height difference.

In some embodiments, after the step S609, the second region 1112 of the light receiving surface 111 and the fourth region 1122 of the back surface 112 may be provided with the pyramid structures, that is, the second region 1112 and the fourth region 1122 may form the textured surfaces.

In some embodiments, after the step S609, the second region 1112 of the light receiving surface 111 and the fourth region 1122 of the back surface 112 may form polished surfaces.

S610: performing second etching on the substrate 11 to remove the borosilicate glass layer 122 on the first regions 1111 and the phosphosilicate glass layer 132 on the third regions 1121, so as to form the structure shown in FIG. 12.

In the step S610, the substrate 11 may be etched by using a chemical solution to remove the borosilicate glass layer 122 on the first region 1111 and the phosphosilicate glass layer 132 on the third region 1121, while the first diffusion layer 121 directly facing the part of the borosilicate glass layer 122 is reserved and the second diffusion layer 131 directly facing the part of the phosphosilicate glass layer 132 is reserved.

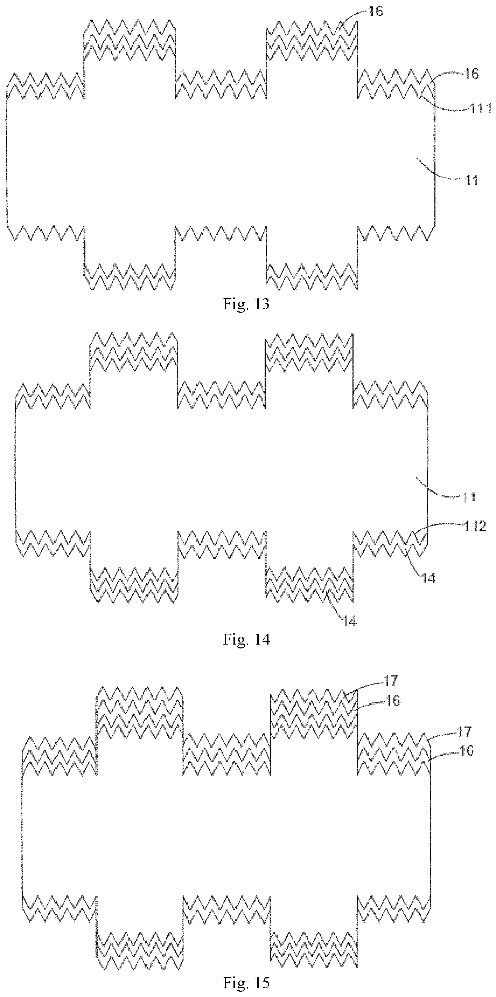

S611: as shown in FIG. 13, forming a second passivation layer 16 on the light receiving surface 111 of the substrate 11. In some embodiments, the second passivation layer has fixed positive charges.

S612: as shown in FIG. 14, forming a first passivation layer 14 on the back surface 112 of the substrate 11. In some embodiments, the first passivation layer has fixed negative charges.

In some embodiments, it is possible to perform the step S612 first, and then perform the step S611.

The first passivation layer 14 and the second passivation layer 16 may be formed by a chemical vapor deposition method, a physical vapor deposition method, a plasma enhanced chemical vapor deposition method, or an atomic layer deposition method.

S613: as shown in FIG. 15, forming a second anti-reflection layer 17 on a side of the second passivation layer 16 away from the substrate 11.

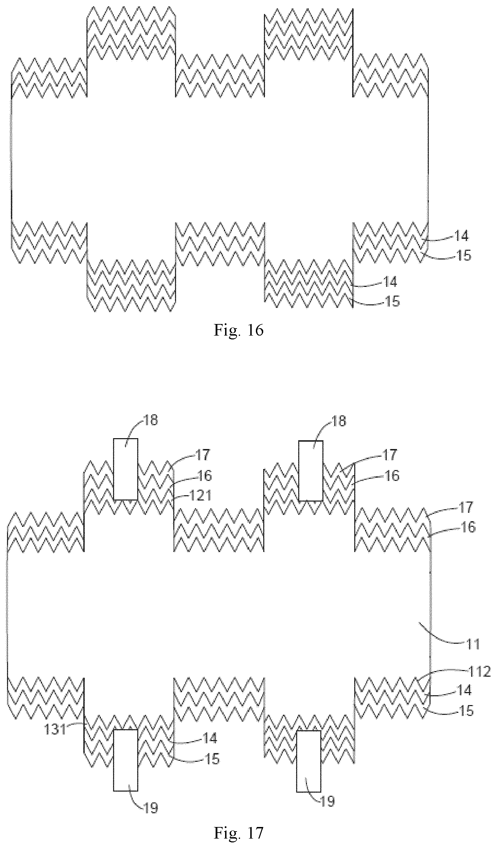

S614: as shown in FIG. 16, forming a first anti-reflection layer 15 on a side of the first passivation layer 14 away from the substrate 11.

In some embodiments, it is possible to perform the step S614 first, and then perform the step S613.

The first anti-reflection layer 15 and the second anti-reflection layer 17 may be formed by a chemical vapor deposition method, a physical vapor deposition method, a plasma enhanced chemical vapor deposition method, or an atomic layer deposition method.

S615: performing screen printing.

In the step S615, metal paste which may be silver paste or silver-aluminum paste may be printed on the first region of the light receiving surface and the third region of the back surface of the substrate.

S616: performing sintering and light annealing to form the structure shown in FIG. 17.

The metal paste is sintered to form a first electrode 18 and a second electrode 19. In a light annealing process, the solar cell may be irradiated with light of a specific wavelength and energy, so that defects and stress inside the substrate 11 are repaired to improve the electrical performance of the solar cell.

S617: as shown in FIG. 17, performing laser-assisted sintering on the back surface 112 of the substrate 11.

In a laser-assisted sintering process (LECO), the high energy and electric field effects of the laser can be used to promote good contact between the metal second electrode 19 and the substrate 11, thus reducing contact resistance. In the step S617, the back surface 112 may be irradiated with the laser, and the laser may be at least one of infrared light, red light, and green light.

In some embodiments, in the step S617, the light receiving surface 111 and the back surface 112 of the substrate 11 may be simultaneously subjected to the laser-assisted sintering.

The preparation process of the solar cell in the embodiments of the present disclosure is simple, and steps, such as deposition of polycrystalline silicon and introduction of doping elements, are avoided, thereby simplifying a production process of the solar cell and reducing the preparation difficulty and the preparation cost of the solar cell. On the other hand, in the preparation process of the solar cell, the back surface of the substrate is processed by using a laser-assisted sintering technology, so as to realize good ohmic contact between the second electrode and the substrate and optimize the electrical performance of the solar cell.

With the above solar preparation method, the first diffusion layer is only located in the first region, and the first diffusion layer only forms a PN junction together with the substrate corresponding to the first region, so that Auger recombination and surface recombination on the front surface of the substrate are reduced, the service life of minority carriers is prolonged, and the open-circuit voltage and the short-circuit current of the solar cell are increased, thereby improving the electrical performance of the solar cell. The second diffusion layer is only located in the third region, so that Auger recombination on the back surface of the substrate is reduced, the recombination rate on the back surface of the substrate is reduced, and a passivation effect is improved. The first passivation layer with the fixed negative charge in contact with the substrate is arranged, and the negative charge attribute of the first passivation layer forms field passivation by regulating and controlling an energy band structure and carrier distribution of the substrate, so that the recombination rate of the surface of the substrate is reduced, the service life of the minority carrier is prolonged, and the open-circuit voltage and the short-circuit current are increased, thereby improving the efficiency of the solar cell and then improving the reliability of the solar cell.

In one or more possible implementations, the step of forming a first passivation layer on the back surface of the substrate includes: forming the first passivation layer with the thickness D1 satisfying the requirement of 0.8 nm≤D1≤3 nm on the back surface of the substrate. The effect of the first passivation layer is described in detail above and not repeated herein.

In one or more possible implementations, the preparation method of a solar cell further includes: forming the first anti-reflection layer with the thickness D2 satisfying the requirement of 60 nm≤D2≤100 nm on the side of the first passivation layer away from the substrate, and the first anti-reflection layer includes a silicon oxide layer, a silicon nitride layer and a silicon oxynitride layer which are arranged in a direction away from the substrate. The second passivation layer with the thickness D6 satisfying the requirement of 0.8nm≤D6≤3nm is formed on the light receiving surface of the substrate. The second anti-reflection layer with the thickness D7 satisfying the requirement of 60nm≤D7≤100nm is formed on the side of the second passivation layer away from the substrate. The effects of the first anti-reflection layer, the second anti-reflection layer and the second passivation layer are described in detail above and not repeated herein.

In one or more possible implementations, in the step of performing laser-assisted sintering on the back surface of the substrate, a reverse bias voltage of 8 V to 16 V is applied to the substrate, laser power is 20 W to 100 W, and the scanning speed of the laser is 20,000 mm/s to 70,000 mm/s. By designing the parameters of the laser-assisted sintering process, the effects of reducing contact resistance and improving ohmic contact quality are achieved, and then, the photoelectric conversion efficiency of the solar cell is improved.

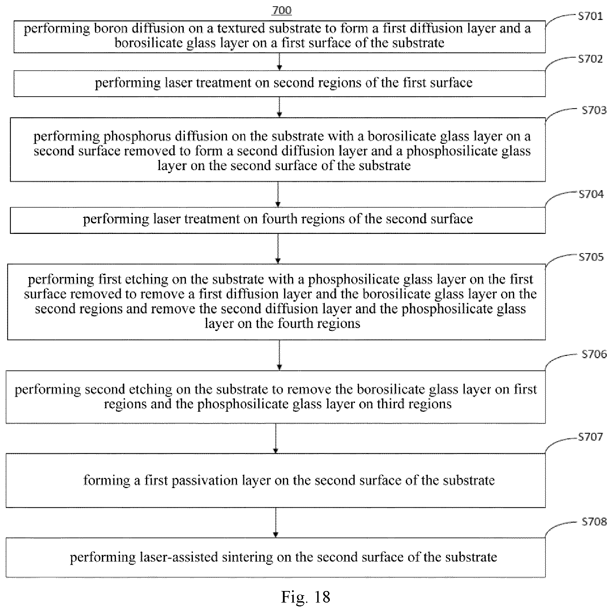

As shown in FIG. 18, another embodiment of the present disclosure provides a preparation method 700 of a solar cell, including:
Step S701: performing boron diffusion on a textured substrate to form a first diffusion layer and a borosilicate glass layer on a light receiving surface of the substrate. The step S701 is the same as the above step S602 and is not repeated herein.
Step S702: performing laser treatment on second regions of the light receiving surface. The step S702 is the same as the above step S603 and is not repeated herein.
Step S703: performing phosphorus diffusion on the substrate with the borosilicate glass layer on a back surface removed to form a second diffusion layer and a phosphosilicate glass layer on the back surface of the substrate. The step S203 is the same as the above step S606 and is not repeated herein.
Step S704: performing laser treatment on fourth regions of the back surface. The step S704 is the same as the above step S607 and is not repeated herein.
Step S705: performing first etching on the substrate with the phosphosilicate glass layer on the light receiving surface removed to remove the first diffusion layer and the borosilicate glass layer on the second regions and remove the second diffusion layer and the phosphosilicate glass layer on the fourth regions. The step S705 is the same as the above step S609 and is not repeated herein.
Step S706: performing second etching on the substrate to remove the borosilicate glass layer on first regions and the phosphosilicate glass layer on third regions. The step S706 is the same as the above step S610 and is not repeated herein.
Step S707: forming a first passivation layer on the back surface of the substrate. The step S207 is the same as the above step S612 and is not repeated herein.
Step S708: performing laser-assisted sintering on the back surface of the substrate. The step S208 is the same as the above step S617 and is not repeated herein.

## Claims

1. A solar cell, comprising:
a substrate comprising a light receiving surface and a back surface, wherein the light receiving surface comprises first regions and second regions arranged alternately, and the back surface comprises third regions and fourth regions arranged alternately;
a first diffusion layer located on the first regions or inside the substrate corresponding to the first regions, wherein the first diffusion layer has an opposite conductivity type to the substrate;
a second diffusion layer located inside the substrate corresponding to the third regions, wherein the second diffusion layer has an opposite conductivity type to the first diffusion layer;
a first passivation layer located on the third regions and the fourth regions, wherein the first passivation layer covers the second diffusion layer and contacts the substrate;
first electrodes arranged on the first regions in one-to-one correspondence and electrically connected to the first diffusion layer; and
second electrodes arranged on the third regions in one-to-one correspondence, wherein at least a portion of the first electrodes penetrates through the first passivation layer to be electrically connected to the second diffusion layer.

2. The solar cell according to claim 1, wherein the first passivation layer has fixed negative charges.

3. The solar cell according to claim 2, wherein the first passivation layer is made of one or more of aluminum oxide, silicon oxynitride, zirconium oxide, hafnium oxide and arsenic oxide; and
a thickness D1 of the first passivation layer satisfies: 0.8 nm≤D1≤3 nm.

4. The solar cell according to claim 3, wherein the thickness D1 of the first passivation layer satisfies: 0.9 nm≤D1≤2.8 nm.

5. The solar cell according to claim 1, further comprising a first anti-reflection layer, wherein the first anti-reflection layer is located on a side of the first passivation layer away from the substrate; and
a thickness D2 of the first anti-reflection layer satisfies: 60 nm≤D2≤100 nm.

6. The solar cell according to claim 5, wherein the thickness D2 of the first anti-reflection layer satisfies: 65 nm≤D2≤ 95 nm.

7. The solar cell according to claim 5, wherein the first anti-reflection layer comprises a silicon oxynitride layer, a silicon nitride layer and a silicon oxide layer arranged in a direction away from the substrate;
a thickness D3 of the silicon oxide layer satisfies: 10 nm≤D3≤30 nm;
a thickness D4 of the silicon nitride layer satisfies: 20 nm≤D4≤30 nm;
a thickness D5 of the silicon oxynitride layer satisfies: 5 nm≤D5≤15 nm.

8. The solar cell according to claim 7, wherein
the thickness D3 of the silicon oxide layer satisfies: 13 nm≤D3≤28 nm;
the thickness D4 of the silicon nitride layer satisfies: 21 nm≤D4≤29 nm; and
the thickness D5 of the silicon oxynitride layer satisfies: 6 nm≤D5≤14 nm.

9. The solar cell according to any one of claims 1 to 7, wherein the first diffusion layer comprises a first doping element, and a doping concentration of the first diffusion layer is 1E19 cm⁻³ to 1E20 cm⁻³; and/or
the second diffusion layer comprises a second doping element, and a doping concentration of the second diffusion layer is 1E20 cm⁻³ to 5E20 cm⁻³.

10. The solar cell according to any one of claims 1 to 7, further comprising a second passivation layer and a second anti-reflection layer;
wherein the second passivation layer is located on the first regions and the second regions, the second passivation layer covers the first diffusion layer and is in contact with the substrate, the second passivation layer has fixed positive charges, and the second anti-reflection layer is located on a side of the second passivation layer away from the substrate;
wherein a thickness D6 of the second passivation layer satisfies: 0.8nm≤D6≤3nm, and/or, a thickness D7 of the second anti-reflection layer satisfies: 60nm≤D7≤100nm.

11. A photovoltaic module, comprising:
at least one solar cell string comprising a plurality of the solar cells according to any one of claims 1 to 10;
an encapsulation layer covering a surface of the solar cell string; and
a cover plate disposed on and covering a surface of the encapsulation layer facing away from the solar cell string.

12. A method for manufacturing a solar cell, wherein a substrate of the solar cell comprises a light receiving surface and a back surface, the light receiving surface comprises first regions and second regions arranged alternately, the back surface comprises third regions and fourth regions arranged alternately, and the method for manufacturing the solar cell comprises:
performing boron diffusion on a textured substrate to form a first diffusion layer and a borosilicate glass layer on the light receiving surface of the substrate;
performing laser treatment on the second regions of the light receiving surface;
performing phosphorus diffusion on the substrate with a borosilicate glass layer on the back surface removed, to form a second diffusion layer and a phosphosilicate glass layer on the back surface of the substrate;
performing laser treatment on the fourth regions of the back surface;
performing first etching on the substrate with the phosphosilicate glass layer on the light receiving surface removed, to remove the first diffusion layer and the borosilicate glass layer on the second regions and remove the second diffusion layer and the phosphosilicate glass layer on the fourth regions;
performing second etching on the substrate to remove the borosilicate glass layer on the first regions and the phosphosilicate glass layer on the third regions;
forming a first passivation layer on the back surface of the substrate; and
performing laser-assisted sintering on the back surface of the substrate.

13. The method according to claim 12, wherein the forming the first passivation layer on the back surface of the substrate comprises:
forming, on the back surface of the substrate, the first passivation layer with a thickness D1 satisfying the requirement of 0.8 nm≤D1≤3 nm.

14. The method according to claim 12, further comprising:
forming, on a side of the first passivation layer away from the substrate, a first anti-reflection layer with a thickness D2 satisfying the requirement of 60nm≤D2≤100nm, wherein the first anti-reflection layer comprises a silicon oxide layer, a silicon nitride layer and a silicon oxynitride layer which are arranged in a direction away from the substrate;
forming, on the light receiving surface of the substrate, a second passivation layer with a thickness D6 satisfying the requirement of 0.8 nm≤D6≤3 nm; and
forming, on a side of the second passivation layer away from the substrate, a second anti-reflection layer with a thickness D7 satisfying the requirement of 60 nm≤D7≤100 nm.

15. The method according to any one of claims 12 to 14, wherein during the performing laser-assisted sintering on the back surface of the substrate, a reverse bias voltage of 8 V to 16 V is applied to the substrate, laser power is 20 W to 100 W, and a scanning speed of the laser is 20,000 mm/s to 70,000 mm/s.
